# EUROPÄISCHE PATENTSCHRIFT

(11) **EP 2 907 117 B1**
(45) Veröffentlichungstag und Bekanntmachung des Hinweises auf die Patenterteilung: **24.08.2016**
(21) Anmeldenummer: 13779538.1
(22) Anmeldetag: 09.10.2013
(51) Int. Cl.: G08B 17/103, H01L 23/34, G08B 29/00, H01L 23/24

(54) **INTEGRIERTER SCHALTKREIS ZUM BETRIEB IN EINEM BEREICH MIT IONISIERENDER STRAHLUNG UND MIT EINER AUSGABEMÖGLICHKEIT FÜR EINE STRAHLENDOSISABHÄNGIGE SCHÄDIGUNGSINFORMATION SOWIE GEFAHRENMELDER UND KORRESPONDIERENDES VERFAHREN**
INTEGRATED CIRCUIT FOR OPERATION IN AN AREA WITH IONISING RADIATION AND WITH OUTPUT POSSIBILITY FOR DAMAGE INFORMATION DEPENDENT ON A DOSE OF RADIATION AND WARNING ALARM AND CORRESPONDING METHOD
CIRCUIT INTÉGRÉ DESTINÉ À FONCTIONNER DANS UNE ZONE EXPOSÉE AUX RAYONNEMENTS IONISANTS ET POUVANT DÉLIVRER DES INFORMATIONS SUR DES DÉTÉRIORATIONS EN FONCTION DE LA DOSE DE RAYONNEMENTS, AINSI QU'AVERTISSEUR DE DANGER ET PROCÉDÉ CORRESPONDANT

(30) Priorität: 10.10.2012 DE 102012218486; 18.10.2012 US 201213655029
(43) Veröffentlichungstag der Anmeldung: 19.08.2015
(73) Patentinhaber: Siemens Schweiz AG, 8047 Zürich (CH)
(72) Erfinder: AEBERSOLD, Hans, 8906 Bonstetten (CH)
(74) Vertreter: Maier, Daniel Oliver
(86) Internationale Anmeldenummer: PCT/EP2013/071035
(87) Internationale Veröffentlichungsnummer: WO 2014/056976

(56) Entgegenhaltungen:
- EP-A1- 2 595 126
- WO-A2-02/11147
- DE-A1-102005 061 358
- DE-C1- 10 034 262

## Beschreibung

Die Erfindung betrifft einen integrierten Schaltkreis, insbesondere einen Mikrocontroller, zum Betrieb in einem Bereich mit ionisierender Strahlung.

Die Erfindung betrifft weiterhin einen Gefahrenmelder zum Betrieb in einem Bereich mit ionisierender Strahlung, insbesondere im Nuklearbereich. Der Gefahrenmelder weist zumindest eine Detektoreinheit zur Detektion zumindest einer Gefahrenkenngrösse, zumindest einen integrierten Schaltkreis sowie weitere elektrische Bauelemente zur Ausgabe eines Meldersignals auf.

Schliesslich betrifft die Erfindung ein Verfahren zur Ermittlung einer Schädigungsinformation eines integrierten Schaltkreises durch eine auf diesen einwirkende ionisierende Strahlung.

Ein integrierter Schaltkreis, in der Kurzform auch als IC (für Integrated Circuit) bezeichnet, ist eine auf einem Halbleitersubstrat bzw. auf einem Halbleiterchip untergebrachte elektronische Schaltung. Er wird folglich auch als Festkörperschaltkreis oder monolithischer Schaltkreis bezeichnet. Ein derartiger integrierter Schaltkreis weist typischerweise eine Vielzahl miteinander verdrahteter elektronischer Bauelemente auf. Das Halbleitermaterial, aus dem der integrierte Schaltkreis gefertigt ist, ist vorzugsweise Silizium. Es kann alternativ ein Germanium-, Galliumarsenid-, Siliziumkarbid- oder ein anderes geeignetes Halbleitermaterial sein. Vorzugsweise wird zur technischen Realisierung der Halbleiterbauelemente des integrierten Schaltkreises ein CMOS-Halbleiterprozess (CMOS für Complementary Metal Oxid Semiconductor) verwendet. Alternativ kann auch ein PMOS- oder NMOS-Halbleiterprozess, ein bipolarer Halbleiterprozess oder eine Kombination davon, wie z.B. ein BiCMOS-Halbleiterprozess, verwendet werden.

Bei den Gefahrenmeldern handelt es sich z.B. um Brandmelder, wie z.B. um optische Rauchmelder oder um Hitzemelder. Optische Rauchmelder können z.B. auf dem Streulichtprinzip oder auf dem optoakustischen Prinzip basieren. Ist der Gefahrenmelder ein Hitzemelder, so wird die aktuell in der Umgebung des Hitzemelders vorliegende Temperatur erfasst, wie z.B. mittels eines temperaturabhängigen Widerstands. Die betrachteten Gefahrenmelder können auch Rauchgasmelder sein, welche einen Gassensor als Detektoreinheit aufweisen, wie z.B. einen Gas-FET (FET für Field Effect Transistor). Ferner kann es sich bei den Gefahrenmeldern um Bewegungsmelder handeln, welche zur Bewegungsdetektion eine PIR-Detektoreinheit (PIR für Passive Infrared) aufweisen. Die betrachteten Gefahrenmelder können auch Kombinationen der zuvor genannten Detektoreinheiten aufweisen.

Der Gefahrenmelder kann auch als linearer Rauchmelder ausgebildet sein, der auf dem Extinktionsprinzip basiert. Derartige lineare Rauchmelder werden insbesondere in grossen oder schmalen Räumen, beispielsweise in Korridoren, Lager- und Fabrikationshallen und in Flugzeughangars, eingesetzt und unterhalb der Decke an den Wänden montiert. In einer ersten Ausführungsform liegen Sender und Empfänger einander gegenüber, und es ist kein Reflektor erforderlich. In einer zweiten Ausführungsform wird der vom Sender ausgesandte Lichtstrahl über einen Reflektor zurück zu einem Empfänger umgelenkt. Sender und Empfänger sind benachbart zueinander angeordnet. Die Messtrecke derartiger linearer Rauchmelder liegt typischerweise im Bereich von 20 m bis 200 m, die im Falle der ersten Ausführungsform einer der Messstrecke entsprechenden Distanz zwischen Sender und Empfänger entspricht. Bei der zweiten Ausführungsform entspricht die Distanz zwischen Sender/Empfänger und dem Reflektor der Hälfte der Messstrecke.

Mit ionisierender Strahlung ist eine Teilchenstrahlung oder eine elektromagnetische Strahlung mit Ionisationsenergien von 5 eV und mehr bezeichnet, welche in der Lage ist, Elektronen aus Atomen oder Molekülen herauszuschlagen, sodass positiv geladene Ionen oder Molekülreste zurückbleiben.

Manche ionisierende Strahlung geht von radioaktiven Stoffen aus, wie z.B. in einem Bereich mit erhöhter, insbesondere mit hoher radioaktiver Strahlung. Derartige Bereiche können z.B. ein Nuklearbereich oder der Weltraum sein. Mit Nuklearbereiche sind insbesondere räumlich abgegrenzte Bereiche zum Beispiel innerhalb eines Kernkraftwerkes, einer kerntechnischen Wiederaufbereitungsanlage oder eines End- oder Zwischenlagers für radioaktiven Abfall gemeint.

Ionisierende bzw. radioaktive Strahlung hat im Allgemeinen einen destruktiven schädigenden Einfluss auf elektronische Bauteile und insbesondere auf Halbleiterbauelemente. Derartige Bauelemente weisen sehr feine Halbleiterstrukturen von weniger als 1 µm, insbesondere von weniger als 100 nm auf. Alle Arten hochenergetischer ionisierender Strahlung treten dabei in Wechselwirkung mit einem Halbleiter-Kristall. Während die Alpha- und Betastrahlung als Teilchenstrahlung bereits durch weniger Millimeter dicke Materialdicken abgeschirmt werden kann, wie z.B. durch ein Gehäuseblech oder eine Kunststoffgehäuse, ist eine wirksame Abschirmung gegen die elektromagnetische Gammastrahlung nur mit hohem Materialaufwand möglich. Je nach Abschirmungsanforderung können Bleiabschirmungen mit Abschirmdicken von einem Meter und mehr erforderlich sein. Auch wenn eine Abschirmung gegen Alpha- und Betastrahlung vergleichsweise einfach möglich ist, so hat die Einwirkung der Gammastrahlung auf die Abschirmung oder auf das Gehäuse der Halbleiterbauelemente dennoch zur Folge, dass in geringem Umfang auch sekundäre Alpha- und Betateilchen entstehen, die ihrerseits in Wechselwirkung mit dem Halbleiter-Kristall treten. Durch die Wechselwirkung eines solchen eingestrahlten Teilchens mit einem Gitteratom kann dieses aus dem Gitterverband herausgelöst werden, und es entsteht eine Fehlstelle.

Das freie Atom kann, wenn es genügend übertragene Stossenergie besitzt, weitere Atome herausschlagen, oder in eine Zwischengitterposition wandern. Es bildet sich ein sogenannter Leerstellen-Zwischengitteratom-Komplex.

Ein wichtiger Einfluss einwirkender Strahlung ist die Erzeugung von Kristalldefekten, die zusätzliche Energiezustände innerhalb des verbotenen Bandes und damit Rekombinationszentren generieren. Diese Effekte treten beschleunigt bei Halbleitermikrostrukturen mit erhöhtem Komplexitätsgrad auf, wie z.B. bei Mikrocontrollern, Mikroprozessoren, ASICs oder FPGAs. Widerstände oder Kondensatoren sind hingegen aber kaum betroffen.

Aus diesem Grund werden vorzugsweise robuste diskrete Halbleiterbauelemente wie Transistoren oder Dioden eingesetzt, um eine beschleunigte Degenerierung der elektrischen Parameter in der Schaltung zu berücksichtigen, zumal überwiegend strahlungsfeste, ältere integrierte Halbleiterbauteile, wie z.B. ICs, Logikgatter etc., die eine Strukturgrössen von mehr 1 µm aufweisen, aufgrund der weit fortgeschrittenen Miniaturisierung kaum mehr auf dem Halbleitermarkt erhältlich sind.

Durch die Verwendung diskreter Halbleiterbauelement kann somit eine minimale Lebensdauer, wie z.B. von 3 Jahren, entsprechend den einschlägigen Anforderungen, wie z.B. denen bei einem Kernkraftwerk, realisiert werden. Eine solche Anforderung kann z.B. sein, dass ein Brandmelder eine Strahlendosis bzw. eine Energiedosis von 0.25 Gy in einem Zeitraum von 3 Jahre "aushalten" muss. Mit Gy (für Gray, = 100 rad) ist dabei die SI-Einheit der absorbierten Energiedosis D bezeichnet. Die auf die Zeit bezogene absorbierte Energiedosis wird dabei als Dosisrate oder Dosisleistung bezeichnet.

Eine ausführliche Beschreibung des Einflusses radioaktiver Strahlung auf elektronische Halbleiterbauteile, insbesondere der damit verbundenen zeitlich kumulierten oder zeitlich vorübergehenden Schädigung solcher Halbleiterkomponenten, ist in der Dissertation "Bauelemente-Degradation durch radioaktive Strahlung und deren Konsequenzen für den Entwurf strahlenresistenter elektronischer Schaltungen" von Detlef Brumbi, Fakultät für Elektrotechnik an der Ruhr-Universität Bochum, 1990, beschrieben.

In der Publikation JPL D-33339 des Jet Propulsion Laboratory (JPL) des California Institute of Technology (CIT), Pasadena, California, USA, vom 6. Juni 2009, mit dem Titel "Test Method for Enhanced Low Dose Rate Damage (ELDRS) Effects in Integrated Circuits for Outer Planetary Mission" wurden mit Blick auf die geplante Jupiter Europa Orbiter (JEO) Mission unterschiedliche integrierte Schaltkreise, wie Spannungsregler, Operationsverstärker und Komparatoren in Bipolar- und BiCMOS-Technologie auf ihre Strahlungsempfindlichkeit hin mittels eines zweistufigen beschleunigten Testverfahrens untersucht. Zum Beschleunigen des Tests wurden im Vergleich zu den während der Mission erwarteten realen Dosisraten höhere Dosisraten verwendet. Ein realer Test mit der für die gesamte Mission zu erwartenden kumulierten Strahlendosis von bis zu 1000 krad(Si) würde dagegen zu viel Zeit in Anspruch nehmen und wäre daher unpraktikabel. Bei dem vorgeschlagenen ELDRS- Test werden die Schaltkreise zuerst mit einer geringen Dosisrate von maximal 10 mrad(Si)/s bis zu einer Strahlendosis von 30 bis 50 krad bestrahlt. Anschliessend werden die Schaltkreise mit einer Dosisrate von 40 mrad(Si) bis zum Erreichen der geforderten gesamten Strahlendosis bestrahlt.

Im Appendix 1 der Publikation ist auch offenbart, dass während der Bestrahlungstests neben der Erhöhung der Dosisrate auch die Temperatur der Schaltkreise erhöht werden kann, um die dadurch bedingte Erhöhung der Bildungsrate von induzierten Lochstellen durch eine thermisch bedingte Erhöhung einer gegengerichteten Rekombinationsrate zu kompensieren. Es ist auch offenbart, dass, wenn die Schaltkreistemperatur zu hoch gewählt wird ("If the temperature is too high, the damage may actually anneal, as shown in the second figure for the Motorola LM324"), wie im Beispiel der Figuren 10 und 11 mit 135°C, die eigentlich zu ermittelnde Schädigung des Schaltkreises durch den "Annealing-Effekt" in unerwünschter Weise wieder verschwindet.

Ausgehend von dem eingangs genannten Stand der Technik ist es eine Aufgabe der vorliegenden Erfindung, einen integrierten Schaltkreis mit erhöhter Lebensdauer für einen (bestimmungsgemässen) Betrieb in einem Bereich mit ionisierender Strahlung anzugeben.

Es ist eine weitere Aufgabe der Erfindung, einen verbesserten Gefahrenmelder für den Einsatz in einem (bestimmungsgemässen) Bereich mit ionisierender Strahlung anzugeben.

Schliesslich ist es eine Aufgabe der vorliegenden Erfindung, ein besonders einfaches Verfahren anzugeben, welches die Ermittlung einer Schädigungsinformation eines integrierten Schaltkreises erlaubt, der einer einwirkenden ionisierenden Strahlung ausgesetzt wird.

Diese Aufgaben werden durch die Gegenstände der unabhängigen Patentansprüche gelöst. Vorteilhafte Ausführungsformen der vorliegenden Erfindung sind in den abhängigen Ansprüchen beschrieben.

Erfindungsgemäss weist der integrierte Schaltkreis zumindest einen Teil einer Temperaturregelungsschaltung zur geregelten Erhöhung der Schaltkreistemperatur auf einen vorgegebenen, im Wesentlichen konstanten Betriebstemperaturwert auf. Hierzu wird die elektrische Leistungsaufnahme des Schaltkreises um eine regelbare elektrische Zusatzleistung erhöht. Der Schaltkreis weist zudem eine Ausgabemöglichkeit für eine Schädigungsinformation des integrierten Schaltkreises durch die auf ihn einwirkende ionisierende Strahlung auf, wobei die Schädigungsinformation aus einer strahlendosisabhängigen Abnahme der regelbaren elektrischen Zusatzleistung ermittelbar ist.

Mit "aus einer strahlendosisabhängigen Abnahme der regelbaren elektrischen Zusatzleistung" ist eine von der absorbierten Strahlendosis des integrierten Schaltkreises abhängige Abnahme der regelbaren elektrischen Zusatzleistung gemeint. Die absorbierte Strahlendosis wird auch als TID für "Total Irradiated Dose" oder für "Total Ionizing Dose" abgekürzt. Die physikalische Einheit hierfür ist "rad" oder "Gy" (für Gray = 100 rad). Anstelle des Fachbegriffs "Strahlendosis" kann auch der Begriff "Energiedosis" verwendet werden.

Ursache für die strahlendosisabhängige Abnahme der erforderlichen regelbaren elektrischen Zusatzleistung ist die strahlendosisabhängige Zunahme der Leckstromverlustleistung im integrierten Schaltkreis.

Der Erfindung liegt die Erkenntnis zugrunde, dass mit zunehmender strahlen- bzw. energiedosisabhängiger Leckstromverlustleistung, die ihrerseits den integrierten Schaltkreis aufheizt, nun die zum Aufheizen des integrierten Schaltkreises auf die vorgegebene Betriebstemperatur erforderliche regelbare Zusatzleistung bzw. die zusätzliche Heizleistung entsprechend reduziert werden kann. Diese Zunahme der Leckstromverlustleistung respektive die Abnahme der erforderlichen Zusatzleistung ist dann ein Mass für die strahlendosisabhängige Schädigung des integrierten Schaltkreises.

Die Abnahme der regelbaren elektrischen Zusatzleistung ist somit ein Langzeittrend, der sich bei sonst unveränderten, im Wesentlichen gleichen äusseren Randbedingungen wie gleiche Umgebungstemperatur und gleiche elektrische Verlustleistung des integrierten Schaltkreises, abzüglich der regelbaren elektrischen Zusatzleistung für das zusätzliche Heizen des integrierten Schaltkreises, einstellt. Das heisst also der reinen elektrischen Verlustleistung, die der integrierte Schaltkreis für seinen bestimmungsgemässen Einsatz benötigt, wie z.B. bei einem Überwachungsbetrieb von erfassten und zu verarbeitenden Brandkenngrössen bei einem Rauchmelder.

Durch die ermittelte Schädigungsinformation kann vorteilhaft das Lebensdauerende bzw. die noch verbleibende Restbetriebszeit für den integrierten Schaltkreis bestimmt werden. Die Schädigungsinformation kann z.B. ein Schädigungsgrad sein, wie z.B. ein Prozentwert oder ein Zahlenwert. Im Falle eines Prozentwertes kann ein Wert von 0% den Neuzustand und ein Wert von 100% den Ausfallzustand eines integrierten Schaltkreises kennzeichnen. Der 0%-Wert kann z.B. einem Leckstromverlustleistungswert im Neuzustand, der 100%-Wert einem Leckstromverlustleistungswert beim Ausfall des integrierten Schaltkreises entsprechen. Dazwischen liegende Prozentwerte können aus dem Verhältnis von aktuellem Leckstromverlustleistungswert zur Differenz zwischen dem Leckstromverlustleistungswert im ausgefallen Zustand zum Leckstromverlustleistungswert im Neuzustand abgeleitet werden. Die Leckstromverlustleistungswerte können auch messtechnisch im Rahmen einer Typ- oder Musterprüfung für einen jeweiligen integrierten Schaltkreis, empirisch oder auf Basis eines rechnergestützten Simulationsmodells ermittelt werden.

Die Schädigungsinformation kann auch eine Schädigungsmeldung sein, welche als Signal, als Text, als Datenwort oder als eine binäre Information, wie z.B. schadfrei/geschädigt, ausgegeben wird.
Ein weiterer Vorteil ist, dass auf einen Strahlungssensor zur Erfassung ionisierender Strahlung verzichtet werden kann.

Die Zunahme der Leckstromverlustleistung kann z.B. durch im Schaltkreis integrierte Strommesssensoren ermittelt werden. Vorzugsweise erfolgt die Ermittlung durch Auswerten der Ein- und Ausschaltzeiten für das Zuschalten von chipinternen Funktionsbaugruppen, die nicht notwendigerweise oder nicht ständig für den ordnungsgemässen Betrieb des integrierten Schaltkreises erforderlich sind. Die Funktionsbaugruppe kann z.B. eine A/D-Umsetzer oder eine D/A-Umsetzer sein, der nicht benötigt wird, jedoch eine Wärmeverlustleistung nach dem Einschalten erzeugt. Nimmt z.B. mit der Betriebszeit des integrierten Schaltkreises in ionisierender Umgebung das Verhältnis von Einschaltzeit zu Ausschaltzeit als Stellgrösse für die Heizungsregelung des integrierten Schaltkreises ab, so korreliert diese Abnahme mit einer Zunahme der strahlungsbedingten Schädigung des integrierten Schaltkreises.

Die Ausgabe der Schädigungsinformation kann z.B. über zumindest einen Anschlusspin des integrierten Schaltkreises elektrisch ausgegeben werden, wie z.B. als analoger Spannungswert, in digital kodierter Form über mehrere Anschlusspins oder als serielle Folge von Datenbits über einen Anschlusspins. Er kann alternativ auch auf optischem Wege wie z.B. über eine im Schaltkreis integrierte Leuchtdiode oder drahtlos mittels einer im Schaltkreis integrierten Funkschnittstelle ausgegeben werden.

Nach einer Ausführungsform liegt der vorgegebene, im Wesentlichen konstante Betriebstemperaturwert in einem Bereich von 70°C bis zu einem maximalen, von einem Hersteller des integrierten Schaltkreises spezifizierten Betriebstemperaturwert. Der integrierte Schaltkreis ist dabei insbesondere für einen erweiterten Temperaturbereich oder für einen Hochtemperaturbereich ausgelegt. Der maximale spezifizierte Betriebstemperaturwert liegt z.B. bei 90, 100, 110 oder 120°C. Er kann auch bei noch höheren Temperaturwerten liegen, wie z.B. bei 150°C.

Einer weiteren Ausführungsform zufolge weist der Schaltkreis einen Halbleiterchip und ein Chipgehäuse auf. Es ist auf dem Halbleiterchip, welches auch als Substrat bezeichnet wird, zumindest ein elektrisches Heizelement zum Beheizen des integrierten Schaltkreises appliziert. Es kann alternativ oder zusätzlich im Chipgehäuse zumindest ein elektrisches Heizelement appliziert sein. Das elektrische Heizelement ist vorzugsweise ein ansteuerbares Halbleiterbauelement, wie z.B. ein in seiner Verlustleistung einstellbarer Bipolartransistor oder ein FET, oder ein ohmscher Widerstand, wie z.B. ein SMD-Widerstand. Es können mehrere derartiger Widerstände flächig verteilt auf dem Halbleiterchip oder im Chipgehäuse appliziert sein.

Nach einer bevorzugten Ausführungsform weist der integrierte Schaltkreis einen Halbleiterchip auf, auf dem ein Temperatursensor, insbesondere eine pn-Diode, zur Erfassung der Schaltkreistemperatur integriert ist. Der Temperatursensor ist dabei Teil der Temperaturregelungsschaltung. Dadurch ist eine genaue sowie schnelle chipinterne Temperaturerfassung möglich. Eine externe Beschaltung des integrierten Schaltkreises ist nicht erforderlich.

Der integrierte Schaltkreis ist insbesondere ein in CMOS-Technologie gefertigter Mikrocontroller, Mikroprozessor, FPGA oder ASIC.

Einer weiteren Ausführungsform zufolge ist der Schaltkreis ein prozessorgestützter Schaltkreis. Es ist zumindest ein Teil der Temperaturregelungsschaltung als Computerprogramm realisiert, welches auf dem integrierten prozessorgestützten Schaltkreis ausgeführt wird. Dadurch ist auf einfache Weise eine Temperaturregelung implementierbar.

Vorzugsweise weist der prozessorgestützte Schaltkreis einen Analog-/Digital-Umsetzer zur Erfassung einer vom Temperatursensor ausgegebenen, mit der Schaltkreistemperatur korrelierenden elektrischen Messgrösse auf. Es wird ein entsprechender Digitalwert durch den prozessorgestützten Schaltkreis zur Temperaturregelung weiterverarbeitet. Die Messgrösse kann z.B. eine am Temperatursensor anliegende Messspannung oder ein durch den Temperatursensor hindurchfliessender Messstrom sein, welche bzw. welcher mit zunehmender Temperatur zunimmt oder alternativ abnimmt.

Vorzugsweise ist der integrierte prozessorgestützte Schaltkreis ein Mikrocontroller. Das zur Temperaturregelung auf dem Mikrocontroller ausgeführte Computerprogramm weist geeignete Programmschritte auf und/oder es steuert ein geeignetes Verlustleistungssteuerungsprogramm an, um interne Funktionsgruppen des Mikrocontrollers derart anzusteuern oder derart zeitweise zuzuschalten, sodass die erforderliche elektrische Leistungsaufnahme zur Regelung der Temperatur des Mikrocontrollers auf den Betriebstemperaturwert eingestellt werden kann. Die Funktionsbaugruppen sind z.B. Timer, Speicher, Takterzeugung, Hardwaremultiplizierer, DMAs (für Direct Memory Access), Watchdog, serielle Schnittstellen, Komparatoren, DACs (für Digital to Analog Converter), ADCs (für Analog to Digital Converter), sowie analoge oder digitale Ausgänge.

Die analogen oder digitalen Ausgänge können z.B. mit einem externen ohmschen Widerstand, wie z.B. mit einem SMD-Widerstand, beschaltet sein, der im Sinne einer Leistungsanpassung so bemessen ist, dass chipintern eine maximale Verlustleistung in Form von Wärme eingebracht wird. Die regelbare Zusatzleistung kann z.B. auch durch Speicherkopieraktionen oder durch Ausführungen von mathematischen Funktionen im Sinne einer Steigerung der CPU- oder Prozessorauslastung erhöht werden. Alternativ oder zusätzlich kann die Taktrate des Prozessor bzw. Mikrocontrollers erhöht werden.

Weiterhin vorzugsweise erfolgt die Ansteuerung und/oder das Zuschalten der internen Funktionsbaugruppen durch das Temperaturregelungsprogramms derart, dass die auf dem Halbleiterchip entstehende Verlustwärme flächenmässig möglichst gleichmässig erfolgt.

Hierzu kann die thermische örtliche Auswirkung einer jeweiligen zugeschalteten Funktionsbaugruppe auf dem integrierten Schaltkreis mittels einer Wärmebildkamera ermittelt werden. Es können dann der Ort sowie die dort entstehende Verlustleistung für jede Funktionsbaugruppe messtechnisch ermittelt werden. Durch geeignete überlagerte Ansteuerung der Funktionsbaugruppen kann somit für einen aktuell erforderlichen Leistungswert für die regelbare elektrische Zusatzleistung ein Zu- und Ausschaltprofil für die Funktionsbaugruppen erstellt werden. Diese Profile können dann in Form geeigneter Programmschritte im Temperaturregelungsprogramm abgebildet wird.

Nach einer Ausführungsform weist das Temperaturregelungsprogramm geeignete Programmschritte auf, um die zur Regelung der Temperatur des integrierten Schaltkreises auf den Betriebstemperaturwert erforderliche regelbare elektrische Zusatzleistung zu ermitteln. Es weist zudem Programmschritte auf, um die Schädigungsinformation des integrierten Schaltkreises aus der Zunahme der Leckstromverlustleistung oder aus der entsprechenden Abnahme der elektrischen Zusatzleistung zu ermitteln und auszugeben. Alternativ oder zusätzlich weist das Temperaturreglungsprogramm Programmschritte auf, um eine Warnmeldung auszugeben, falls die Leckstromverlustleistung einen vorgegebenen Maximalwert überschreitet oder falls die erforderliche Zusatzleistung einen vorgegebenen Minimalwert unterschreitet.

Nach einer besonders vorteilhaften Ausführungsform ist integrierte Schaltkreis zusätzlich wärmeisolierend gekapselt. Die Wärmeisolierung kann z.B. als Kapsel aus Dämmstoff realisiert sein, in welcher der integrierte Schaltkreis sowie gegebenenfalls die weiteren elektrischen Bauelemente aufgenommen sind. Ist der integrierte Schaltkreis auf einem Schaltungsträger appliziert, so kann die Wärmeisolierung als Halbschale aus Dämmstoff realisiert sein, welche den integrierten Schaltkreis von einer Bestückungsseite her umschliesst. Als Dämmstoffe kommen für den vorgesehenen Betriebstemperaturbereich temperaturbeständige Kunststoffe wie z.B. Polyurethan in Form von Hartschaumplatten in Frage. Sie können auch geschäumte Elastomere sein, die auf Neopren-Kautschuk, auf EPDM (für Ethylen-Propylen-Dien-Kautschuk) oder ähnlichen gummiartigen Basismaterialien basieren. Sie können weiterhin z.B. aus geschäumtem Glas bestehen. Die zuvor genannten Materialien müssen bis zur ausgewählten maximalen Betriebstemperatur stabil sein.

Alternativ oder zusätzlich kann die Wärmeisolierung eine Vakuumisolierung nach dem Thermoskannenprinzip sein. In diesem Fall kann der integrierte Schaltkreis in einer weitgehend luftentleerten Kapsel, wie z.B. aus Metall, aufgenommen sein. Die Kapsel kann auch doppelwandig ausgeführt sein, wobei dann der Bereich zwischen der Doppelwand weitgehend luftentleert bzw. mit einem wärmedämmenden Gas, wie z.B. Edelgas, gefüllt ist. Die elektrischen Zuleitungen sind dann entsprechend gasdicht aus dieser Kapsel herausgeführt.

Die Aufgabe der Erfindung wird weiterhin mit einem Gefahrenmelder, insbesondere mit einem Brandmelder gelöst, der zumindest eine Detektoreinheit zur Detektion zumindest einer Gefahrenkenngrösse, zudem elektrische Bauelemente sowie zumindest einen erfindungsgemässen temperaturgeregelten integrierten Schaltkreis aufweist. Der integrierte Schaltkreis ist zumindest zur Weiterverarbeitung der jeweiligen detektierten Gefahrenkenngrösse, zur Ausgabe eines Meldersignals sowie zur Ausgabe einer Schädigungsinformation für den zumindest einen integrierten Schaltkreis durch die einwirkende ionisierende Strahlung eingerichtet.

Der Gefahrenmelder kann auch als linearer Rauchmelder ausgebildet sein. Ein solcher Melder weist eine Rauchmeldereinheit und gegebenenfalls zumindest eine Lichtumlenkeinheit auf. Die Rauchmeldereinheit umfasst die Detektoreinheit, welche ihrerseits einen Lichtsender zur Aussendung eines eine Messstrecke durchquerenden Lichtstrahls und einen Lichtempfänger zum Empfangen des ausgesendeten Lichtstrahls am Ende der Messstrecke aufweist, um die zumindest eine Gefahrenkenngrösse zu detektieren. Die zumindest eine Umlenkeinheit ist zur Umlenkung des vom Lichtsender ausgesandten Lichtstrahls zurück auf den Lichtempfänger vorgesehen. Der lineare Rauchmelder weist elektrische Bauelemente sowie zumindest einen erfindungsgemässen temperaturgeregelten integrierten Schaltkreis auf. Letzterer ist zumindest zur Weiterverarbeitung der jeweiligen detektierten Gefahrenkenngrösse, zur Ausgabe eines Meldersignals und zur Ausgabe einer Schädigungsinformation für den zumindest einen integrierten Schaltkreis durch die einwirkende ionisierende Strahlung vorhanden.

Nach einer Ausführungsform ist die Warnmeldung über den zumindest einen integrierten Schaltkreis an eine signal- oder datentechnisch mit dem Gefahrenmelder verbundene Gefahrenmeldezentrale ausgebbar ist, falls die jeweilige Leckstromverlustleistung einen vorgegebenen Maximalwert überschreitet oder falls die jeweilige elektrische Zusatzleistung einen vorgegebenen Minimalwert unterschreitet.

Schliesslich wird die Aufgabe der Erfindung durch ein zum erfindungsgemässen integrierten Schaltkreis korrespondierenden Verfahren gelöst, welches zur Ermittlung einer Schädigungsinformation eines integrierten Schaltkreises durch eine auf diesen einwirkende ionisierende Strahlung vorgesehen ist. Hierbei wird die Schaltkreistemperatur auf einen vorgegebenen, im Wesentlichen konstanten Betriebstemperaturwert geregelt erhöht, um eine in einem Halbleiterchip des integrierten Schaltkreises durch die ionisierende Strahlung induzierte erhöhte elektrische Löcher-Leitfähigkeit durch eine mit zunehmender Schaltkreistemperatur zunehmende Löcher-Rekombinationsrate zumindest teilweise zu kompensieren. Zur Erhöhung der Schaltkreistemperatur wird die elektrische Leistungsaufnahme des integrierten Schaltkreises um eine regelbare elektrische Zusatzleistung erhöht. Es wird die Schädigungsinformation des integrierten Schaltkreises aus der Zunahme einer strahlendosisabhängigen Leckstromverlustleistung im Schaltkreis oder aus einer entsprechenden Abnahme der erforderlichen elektrischen Zusatzleistung ermittelt und dann ausgegeben.

Die Erfindung sowie vorteilhafte Ausführungen der vorliegenden Erfindung werden am Beispiel der nachfolgenden Figuren erläutert. Dabei zeigen:
- FIG 1: ein Beispiel für eine Gefahrenmeldeanlage mit einer Meldezentrale und mit drei, jeweils über eine Zweidrahtleitung an der Meldezentrale angeschlossene Gefahrenmelder in einem Nuklearbereich,
- FIG 2: ein Beispiel für eine weitere Gefahrenmeldeanlage mit einer Meldezentrale und mit drei über eine gemeinsame Zweidrahtleitung an der Meldezentrale angeschlossene, adressierbare Gefahrenmelder in einem Nuklearbereich,
- FIG 3: ein Diagramm einer beispielhaften Zunahme der strahlendosisabhängigen Leckstromverlustleistung in einem integrierten Schaltkreis sowie einen daraus abgeleiteten Schädigungsgrad des integrierten Schaltkreises gemäss der Erfindung,
- FIG 4: ein Beispiel für einen Temperaturregelkreis zur Regelung der Temperatur eines integrierten Schaltkreises mit Ausgabe einer rechnerisch ermittelten Schädigungsinformation des integrierten Schaltkreises sowie einer Warnmeldung gemäss der Erfindung,
- FIG 5: funktional ein Beispiel für einen in einem Mikrocontroller als integrierter Schaltkreis integrierten Temperaturregelkreis sowie mit einem Temperaturregelungsprogramm zur Regelung der elektrischen Leistungsaufnahme sowie zur Ermittlung und Ausgabe einer Schädigungsinformation des Mikrocontrollers gemäss der Erfindung,
- FIG 6: einen kombinierten Rauchgas-/Hitzemelder als Beispiel für einen Gefahrenmelder mit einem erfindungsgemässen Mikrocontroller,
- FIG 7: einen optischen Rauchmelder als Beispiel für einen Gefahrenmelder mit einem wärmeisolierend gekapselten Mikrocontroller gemäss der Erfindung, und
- FIG 8: ein Beispiel für einen als linearen Rauchmelder ausgebildeten Gefahrenmelder gemäss der Erfindung mit einer Umlenkeinheit und einer Rauchmeldereinheit mit einem erfindungsgemässen Mikrocontroller.

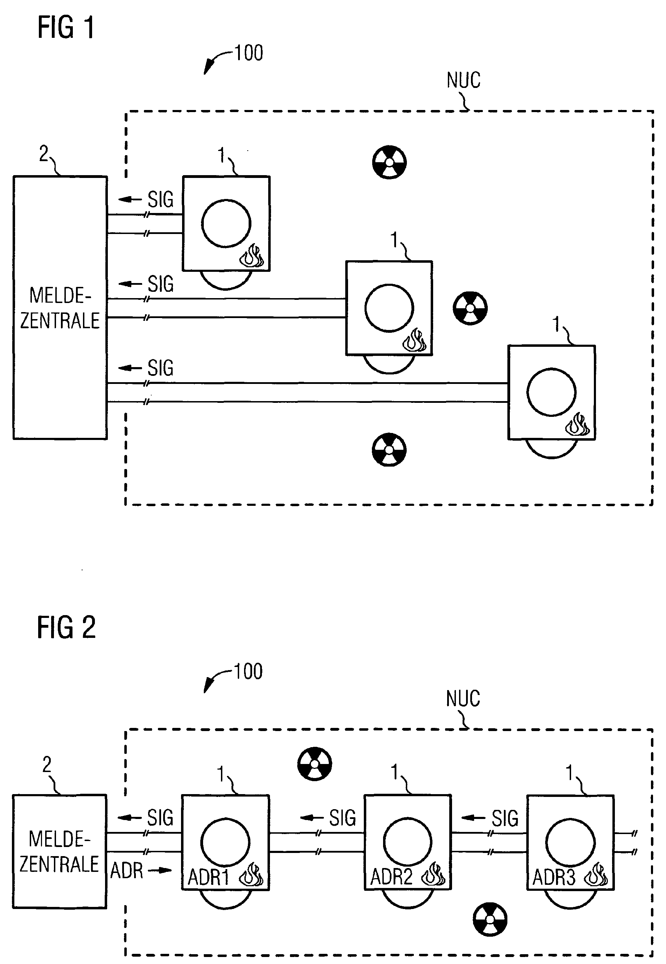

FIG 1 zeigt ein Beispiel für eine Gefahrenmeldeanlage 100 mit einer Meldezentrale 2 und mit drei, jeweils über eine an sich bekannte Zweidrahtleitung an der Meldezentrale 2 angeschlossene Gefahrenmelder 1 in einem Nuklearbereich NUC.

Der Nuklearbereich NUC ist durch drei Symbole für radioaktive Strahlung, also für ionisierende Strahlung gekennzeichnet. Die gezeigten Gefahrenmelder 1 können z.B. optische Rauchmelder sein, welche eine optische Detektoreinheit nach dem Streuprinzip zur Detektion von Rauchpartikeln aufweisen. Ganz allgemein ist die Detektoreinheit zur Detektion zumindest einer Gefahrenkenngrösse bzw. Brandkenngrösse vorgesehen. Der Gefahrenmelder kann alternativ als Hitzemelder eine Temperatur-Detektoreinheit, wie z.B. einen Temperatursensor, zur Branddetektion aufweisen. Weiterhin kann er als Rauchgasmelder einen Gassensor zur Detektion brandtypischer Rauchgase aufweisen. Da die Gefahrenmelder 1 punktförmig in einem zu überwachenden Bereich verteilt angeordnet sind, können diese auch als Punkmelder bezeichnet werden.

Weiterhin ist die Meldezentrale 2 ausserhalb des Nuklearbereichs NUC angeordnet. Sie kann für den Fall, dass zumindest überwiegend nur Brandmelder 1 und insbesondere nur Rauchmelder 1 angeschlossen sind, auch als Brandmeldezentrale bezeichnet werden. Da die Meldezentrale 2 grundsätzlich nicht zum Betrieb in einem Nuklearbereich NUC vorgesehen ist, weist diese typischerweise nur industriegeeignete Halbleiterbauelemente auf. Mit SIG ist ein jeweils vom angeschlossenen Gefahrenmelder 1 ausgegebenes Melder- oder Detektorsignal SIG bezeichnet, welches den Status des Gefahrenmelders angibt. Das Meldersignal SIG kann z.B. ein erster oder zweiter Alarmlevel, eine Betriebsbereitmeldung, eine Fehlermeldung oder ein kodierter Detektorpegel sein. Üblicherweise werden die möglichen Zustände eines solchen Meldersignals SIG in bekannter Weise strommoduliert vom angeschlossenen Gefahrenmelder 1 an die Meldezentrale 2 übertragen. Das jeweilige Meldersignal SIG wird letztlich durch die Meldezentrale 2 erfasst, die dann gegebenenfalls eine Alarmmeldung ausgibt, wie z.B. an eine Feuerwehr.

FIG 2 zeigt ein Beispiel für eine weitere Gefahrenmeldeanlage 100 mit einer Meldezentrale 2 und mit drei über eine gemeinsame Zweidrahtleitung an der Meldezentrale 2 angeschlossene, adressierbare Gefahrenmelder 1 in einem Nuklearbereich NUC.

Mit ADR1-ADR3 ist eine jeweilige Auswahladresse bezeichnet, die in den gezeigten Gefahrenmeldern 1 vorzugsweise manuell eingestellt worden ist. Mit ADR ist eine von der Meldezentrale 2 ausgegebene Melderadresse bezeichnet. Stimmt diese mit einer der Auswahladressen ADR1-ADR3 überein, so ist der jeweilige Gefahrenmelder 1 adressiert. Mit SIG ist wiederum das vom adressierten Gefahrenmelder 1 ausgegebene Meldersignal als Reaktion auf die erfolgte gültige Adressierung bezeichnet.

Vorzugsweise erfolgt die Stromversorgung der Gefahrenmelder 1 sowohl in FIG 1 als auch in FIG 2 über die nicht weiter bezeichneten Zweidrahtleitungen durch die Meldezentrale 2. Die Zweidrahtleitung kann auch als Melderbus bezeichnet werden.

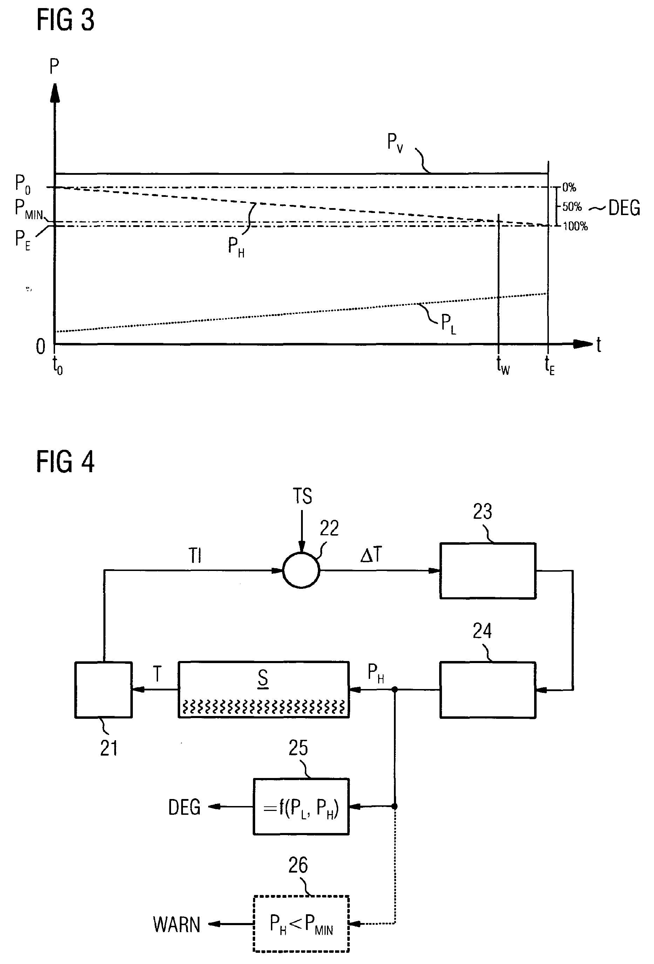

FIG 3 zeigt ein Diagramm einer beispielhaften Zunahme der strahlendosis- bzw. energiedosisabhängigen Leckstromverlustleistung P_{L} in einem integrierten Schaltkreis sowie eine daraus abgeleitete Schädigungsinformation DEG des integrierten Schaltkreises in Form eines Schädigungsgrades gemäss der Erfindung. Mit P_{V} ist die gesamte elektrische Leistungsaufnahme des integrierten Schaltkreises bezeichnet, welche beispielhaft als konstant angenommen wird. Gemittelt betrachtet ist dies z.B. auch der Fall bei Rauchmeldern. Mit t₀ ist der Zeitpunkt bezeichnet, ab dem der Schaltkreis einer ständigen ionisierender Strahlung, wie z.B. einer radioaktiven Strahlung in einem Nuklearbereich, mit beispielhaft konstanter Dosisleistung ausgesetzt wird. Der Zeitpunkt t₀ kann somit auch als Startzeitpunkt für den Beginn der Strahlendisposition bezeichnet werden. Mit t_{E} ist der Zeitpunkt des erwartete Lebensdauerendes, also der Zeitpunkt des technischen Ausfalls des integrierten Schaltkreises bezeichnet, mit P₀ und P_{E} der entsprechende zugehörige elektrische Zusatzleistungswert, und mit P_{MIN} ein Mindestleistungswert für die Ausgabe einer Warnmeldung zum Zeitpunkt t_{W}, dass mit einem baldigen technischen Ausfall des integrierten Schaltkreises zu rechnen ist. Im vorliegenden Beispiel korrespondiert der Mindestleistungswert P_{MIN} mit einem Schädigungsgrad von ca. 90%.

Wie die FIG 3 zeigt nimmt die Leckstromverlustleistung P_{L} durch die schädigende Wirkung der ionisierenden Strahlung mit der Zeit zu. Im Gegenzug reduziert sich die regelbare elektrische Zusatzleistung P_{H}, die benötigt wird, um den vorgegebenen Betriebstemperaturwert des integrierten Schaltkreises aufrechtzuerhalten. Im vorliegenden Beispiel wird für den Schädigungsgrad DEG ein mit der Zeit zunehmender Prozentwert ermittelt, wobei der 0%-Wert den Neuzustand bzw. den Zustand des elektrischen Schaltkreises vor dem Aussetzen der ionisierenden Strahlung bezeichnet. Mit dem 100%-Wert ist das Lebensdauerende des integrierten Schaltkreises bezeichnet.

Die in der FIG 3 linear zunehmende Leckstromverlustleistung P_{L} ist nur beispielhaft zu verstehen. Der tatsächliche Verlauf kann z.B. messtechnisch, empirisch oder mittels eines computerunterstützten Simulationsmodells ermittelt werden.

FIG 4 zeigt ein Beispiel für einen Temperaturregelkreis zur Regelung der Temperatur T eines integrierten Schaltkreises mit Ausgabe einer rechnerisch ermittelten Schädigungsinformation DEG des integrierten Schaltkreises sowie einer Warnmeldung WARN gemäss der Erfindung.

Der Temperaturregelkreis weist hier einen Temperatursensor 21 zur Erfassung eines Temperaturistwerts TI, einen Vergleicher 22 bzw. Differenzbildner zum Vergleich des erfassten Temperaturistwertes TI mit einem vorgegebenen Temperatursollwert TS, einen Regler 23, welchem der ermittelte Differenzwert Δ als Fehlerabweichung zugeführt wird, und schliesslich ein nachfolgendes Stellglied 24 zum Stellen der elektrischen Zusatzleistung P_{H} auf, sodass der integrierte Schaltkreis eine elektrische Leistungsaufnahme P_{L} aufweist, die ausreichend ist, um den vorgegebenen Betriebstemperaturwert TS insbesondere des Halbleiterchips S im Inneren des integrierten Schaltkreises aufrechtzuerhalten. Der Halbleiterchip S ist über sogenannte Bonddrähte mit Anschlusskontakten des integrierten Schaltkreises verbunden, die aus dem Chipgehäuse herausgeführt sind. Die dabei vom Halbleiterchip S über das Chipgehäuse nach aussen abgegebene Wärmeleistung entspricht dabei im Wesentlichen der elektrischen Leistungsaufnahme P_{L}, d.h. der (gesamten) elektrischen Verlustleistung, die letztlich chipintern in Wärme umgesetzt wird.

Mit dem Bezugszeichen 25 ist ein erster Funktionsblock bezeichnet, in welchem aus der ermittelten Leckstromverlustleistung P_{L} bzw. aus der ermittelten erforderlichen Zusatzleistung P_{H} ein aktueller Wert für den Schädigungsgrad als Schädigungsinformation DEG ermittelt und ausgegeben wird. Mit dem Bezugszeichen 26 ist ein zweiter Funktionsblock beschrieben, in welchem die aktuell ermittelte Zusatzleistung P_{H} mit einem Mindestleistungswert P_{MIN} verglichen wird. Es wird dann eine Warnmeldung WARN ausgegeben, um einen nahenden Ausfall des integrierten Schaltkreises zu melden.

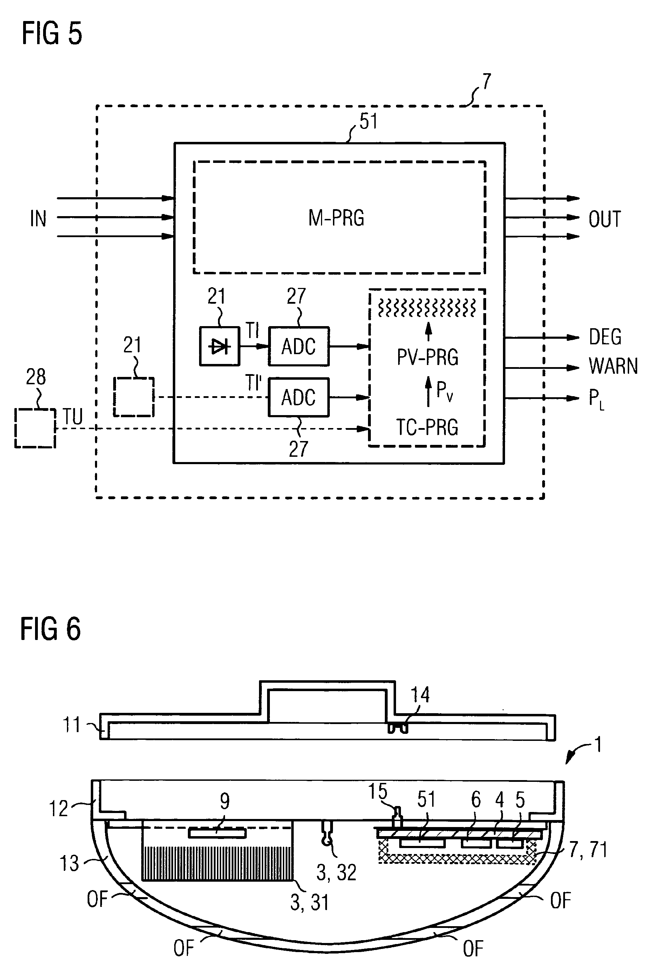

FIG 5 zeigt funktional ein Beispiel für einen in einem Mikrocontroller als prozessorgestützter integrierter Schaltkreis 51 integrierten Temperaturregelkreis sowie mit einem Temperaturregelungsprogramm TC-PRG zur Regelung der elektrischen Leistungsaufnahme P_{V} sowie zur Ermittlung und Ausgabe einer Schädigungsinformation DEG des Mikrocontrollers 51 gemäss der Erfindung.

Allgemein ist der gezeigte integrierte Schaltkreis 51 zum Betrieb in einem Bereich mit ionisierender Strahlung vorgesehen, der zumindest einen Teil einer Temperaturregelungsschaltung zur geregelten Erhöhung der Schaltkreistemperatur T auf einen vorgegebenen, im Wesentlichen konstanten Betriebstemperaturwert aufweist. Hierzu wird die elektrische Leistungsaufnahme P_{V} des Schaltkreises 51 um eine regelbare elektrische Zusatzleistung erhöht. Darüber hinaus weist er eine Ausgabemöglichkeit für eine Schädigungsinformation DEG des integrierten Schaltkreises 51 durch die auf ihn einwirkende ionisierende Strahlung auf, wobei die Schädigungsinformation DEG selbst aus der Zunahme einer strahlendosisabhängigen Leckstromverlustleistung P_{L} im Schaltkreis 51 oder aus einer entsprechenden Abnahme der Zusatzleistung P_{H} ermittelbar ist.

Im vorliegenden Beispiel sind mit IN, OUT an sich bekannte Signaleingänge und Signalausgänge bezeichnet. Erfindungsgemäss ist zumindest ein Teil des Temperaturregelkreises als ein auf dem Mikrocontroller 51 ausführbares Computerprogramm TC-PRG realisiert. Das zur Temperaturregelung auf dem Mikrocontroller ausgeführte Computerprogramm TC-PRG weist erfindungsgemäss geeignete Programmschritte auf und/oder es steuert ein geeignetes Verlustleistungssteuerungsprogramm PV-PRG an, um nicht weiter gezeigte interne Funktionsgruppen des Mikrocontrollers wie Timer, Speicher, Takterzeugung, Hardwaremultiplizierer, DMA, Watchdog, serielle Schnittstellen, Komparatoren, DACs sowie analoge oder digitale Ausgänge derart anzusteuern oder derart zeitweise zuzuschalten, dass die erforderliche elektrische Leistungsaufnahme P_{V} zur Regelung der Temperatur des Mikrocontrollers 51 auf den Betriebstemperaturwert TS eingestellt werden kann.

Im Beispiel der FIG 5 ist mit M-PRG ein Hauptprogramm bezeichnet, welches zur Ausführung der eigentlichen Funktion des Mikrocontrollers 51 ausgeführt wird, wie z.B. zur Steuerung und Regelung eines Gerätes oder einer Anlage, oder - wie z.B. im Falle eines Brandmelders - zur Ansteuerung, Messwerterfassung und Auswertung einer damit verbundenen Detektoreinheit sowie zur Ausgabe einer entsprechenden Alarmmeldung über einen angeschlossenen Melderbus.

Weiterhin weist der prozessorgestützte Schaltkreis einen Analog-/Digital-Umsetzer 27 zur Erfassung einer vom Temperatursensor 21 ausgegebenen, mit der Schaltkreistemperatur T korrelierenden elektrischen Messgrösse auf. Es wird ein entsprechender Digitalwert durch den prozessorgestützten Schaltkreis 51 zur Temperaturregelung weiterverarbeitet. Mit TI ist ein Temperaturistwert TI als korrelierende elektrische Messgrösse bezeichnet.

Der Temperaturistwert TI wird dabei von einem auf dem Mikrocontroller 41 integrierten Temperatursensor 21 in Form einer pn-Diode als elektrische Grösse, wie z.B. als Messspannung, ausgegeben. Wie in der FIG 5 gestrichelt angedeutet, können auch der Teile des Temperaturregelkreises ausserhalb des Mikrocontrollers 51 angeordnet sein, wie hier ein externer Temperatursensor 21. Der externe Temperatursensor 21 ist beispielhaft ausserhalb des Mikrocontrollers 51, aber innerhalb einer Wärmeisolierung 7 angeordnet, welche den Mikrocontroller 51 umgibt. Mit dem Bezugszeichen TI' ist ein entsprechender weiterer Temperaturistwert bezeichnet. Des Weiteren kann ein Umgebungstemperatursensor 25 zur Erfassung einer Umgebungstemperatur ausserhalb der Wärmeisolierung 7 vorgesehen sein, der vom Mikrocontroller 51 zusätzlich erfasst und bei der Temperaturregelung mitberücksichtigt wird.

FIG 6 zeigt einen kombinierten Rauchgas-/Hitzemelder als Beispiel für einen Gefahrenmelder 1 mit einem erfindungsgemässen Mikrocontroller 51.

Im oberen Teil der gezeigten Figur ist ein Meldersockel 11 zu sehen, auf dem der eigentliche Gefahrenmelder 1 lösbar befestigt werden kann. Der Meldersockel 11 ist typischerweise zur vereinfachten Montage der Gefahrenmelder 1 vorgesehen. Dieser wird üblicherweise beabstandet zu weiteren Meldersockeln 11 an der Decke eines zu überwachenden Bereichs montiert. Zugleich dient der Meldersockel 11 zum Anschluss an einen linienförmig oder sternförmig verlegten Melderbus oder zum Anschluss an eine entsprechende Zweidrahtleitung, wie in FIG 1 und FIG 2 gezeigt. Der linienförmige Melderbus wird dabei von einem Meldersockel 11 zum nächsten Meldersockel 11 durchgeschleift, wobei die jeweiligen Leitungen der Zweidrahtleitung elektrisch kontaktiert und zu einem zugehörigen Melderkontakt 14, wie z.B. in Form einer Buchse, weitergeführt werden. Der Melderkontakt 14 ist zum Kontaktieren mit einem entsprechenden Gegenkontakt 15, wie z.B. in Form eines Steckerkontakts, im befestigten Zustand des Gefahrenmelder 1 auf dem Meldersockel 11 vorgesehen. Natürlich kann der Meldersockel 11 auch integraler Bestandteil des Gefahrenmelders 1 selbst sein.

Im unteren Teil der FIG 6 ist eine Schnittdarstellung durch einen erfindungsgemässen Gefahrenmelder 1 zu sehen. Mit dem Bezugszeichen 12 ist ein Grundkörper und mit 13 eine Abdeckung des Meldergehäuses 12, 13 zu sehen. In der Abdeckung 13 sind zudem Öffnungen OF vorhanden, durch welche zu detektierender Rauch, zu detektierende Rauchgase und/oder zu detektierende erhitzte Luft in eine entsprechende, innenliegende Detektoreinheit 3 gelangen kann.

Im vorliegenden Beispiel handelt es sich um einen kombinierten Rauchgas-/Hitzemelder 1 mit einer Rauchgas-Detektoreinheit 31 und einer Temperatur-Detektoreinheit 32 in Form eines temperaturabhängigen Widerstands. Mit dem Bezugszeichen 9 ist ein für spezifische Brandgase sensitiver Gassensor, wie z.B. Gas-FET, bezeichnet. Die entsprechenden Detektorsignale werden dann üblicherweise durch eine elektronische Auswerteeinheit, wie z.B. durch einen Mikrocontroller, ausgewertet. Letztere generiert darauf basierend einen zugeordneten Detektorstatus, der letztendlich auf dem Melderbus ausgegeben wird, wie z.B. eine Alarmmeldung.

Gemäss der Erfindung weist der Gefahrenmelder 1 elektrische Bauelemente 6 sowie zumindest einen erfindungsgemässen temperaturgeregelten integrierten Schaltkreis 51 zumindest zur Weiterverarbeitung der jeweiligen detektierten Gefahrenkenngrösse, zur Ausgabe eines Meldersignals und zur Ausgabe einer Schädigungsinformation für den zumindest einen integrierten Schaltkreis 51 durch die einwirkende ionisierende Strahlung auf. Der integrierte Schaltkreis 51 ist im vorliegenden Beispiel ein in CMOS-Technologie gefertigter Mikrocontroller. Er kann alternativ ein Mikroprozessor, FPGA oder ASIC sein.

Der vorgegebene, im Wesentlichen konstante Betriebstemperaturwert liegt in einem Bereich von 70°C bis zu einem maximalen, von einem Hersteller des Mikrocontrollers 51 spezifizierten Betriebstemperaturwert. Der Mikrocontroller 52 ist insbesondere für einen erweiterten Temperaturbereich oder für einen Hochtemperaturbereich ausgelegt, wie z.B. für militärische Anwendungen.

Der Mikrocontroller 51 sowie weitere elektrische Bauelemente 5, 6 sind dabei auf einem Schaltungsträger 4 angeordnet, wie z.B. auf einer Leiterplatte. Zudem sind die gezeigten Bauelemente 5, 6 thermisch von den beiden Detektoreinheiten 3 entkoppelt. Mit dem Bezugszeichen 5 sind weitere, typischerweise nichtstrahlungsfeste Halbleiterbauelemente bezeichnet, mit dem Bezugszeichen 6 sind typischerweise strahlungsfeste elektrische Bauelemente bezeichnet. Letztere sind z.B. passive Bauelemente wie Widerstände, Spulen oder Kondensatoren oder elektronische Bauteile wie Halbleiterdioden oder Transistoren mit Halbleiterstrukturen im µm-Bereich.

Die thermische Trennung wird im vorliegenden Beispiel durch die räumliche Trennung voneinander erreicht. Zusätzlich kann auch eine im Grundgehäuse 12 oder in der Abdeckung 13 ausgebildete oder angeordnete, nicht weiter gezeigte Trennwand vorhanden sein, welche die beiden Detektoreinheiten 3 von der Leiterplatte 4 mit den Bauelementen 5, 6 thermisch abtrennt.

Im vorliegenden Beispiel sind die Bauelemente 5, 6 durch eine haubenförmige Wärmeisolierhalbschale 71 gegenüber der Umgebung wärmeisoliert. Dadurch reduziert sich der erforderliche Raum zum Aufheizen der nichtstrahlungsfesten Halbleiterbauelemente 5, 51 auf das abgeschlossene Innere der Wärmeisolierhalbschale 71.

Durch die wärmeisolierende Kapselung bzw. durch die thermische Trennung wird zudem verhindert, dass zu detektierender Rauch thermisch abgelenkt und nicht mehr durch die Eintrittsöffnungen OF zu den beiden Detektoreinheiten 31, 32 gelangt.

Ein weiterer Vorteil ist, dass durch die Wärmeisolierung 7 der über den Melderbus zum Heizen erforderliche Strombedarf minimiert wird. Die zum Erreichen und Aufrechterhalten des vorgegebenen Betriebstemperaturwerts der in der Wärmeisolierung 7 aufgenommenen Bauelemente 5, 6, 51 wird durch den erfindungsgemässen Mikrocontroller 51 erreicht, indem die dazu erforderliche Heizleistung durch die regelbare elektrische Zusatzleistung bereitgestellt wird. Dabei wird durch die Wärmeisolierung 7 auch erreicht, dass durch thermische Ausgleichseffekte innerhalb der Wärmeisolierung 7 alle Bauelemente 5, 6, 51 einen im Wesentlichen gleichen Betriebstemperaturwert aufweisen. In diesem Sinne übernimmt der erfindungsgemässe Mikrocontroller 51 auch das Aufheizen und die Aufrechterhaltung der Betriebstemperatur für die anderen Bauelemente 5, 6 mit.

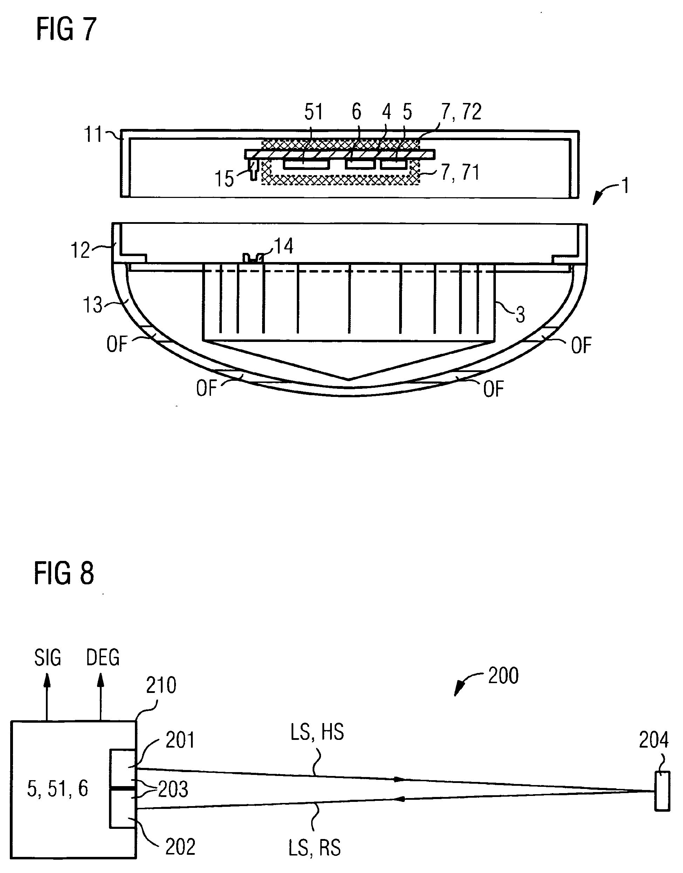

FIG 7 zeigt einen optischen Rauchmelder 1 als Beispiel für einen Gefahrenmelder mit einem wärmeisolierend gekapselten Mikrocontroller 51 gemäss der Erfindung. Im Vergleich zum vorherigen Fall setzt sich die Wärmeisolierung 7 aus einer Wärmeisolierhalbschale 71 und einer gegenüberliegenden, lediglich durch den Schaltungsträger 4 getrennten Wärmeisolierplatte 72 zusammen. Dadurch wird der Grad der Wärmeisolierung gegenüber der Umgebung im Vergleich zur vorherigen Ausführung gesteigert. Mit dem Bezugszeichen 3 ist hier eine optische Detektoreinheit bezeichnet, welche eine nicht weiter bezeichnete optische Messkammer nach dem Streulichtprinzip aufweist.

FIG 8 zeigt ein Beispiel für einen als linearen Rauchmelder 200 ausgebildeten Gefahrenmelder gemäss der Erfindung mit einer Umlenkeinheit 204 und einer Rauchmeldereinheit 210 mit einem erfindungsgemässen Mikrocontroller 51.

Im vorliegenden Beispiel liegen sich die typischerweise als Baueinheit ausgeführte Rauchmeldereinheit 210 und die Umlenkeinheit 204 gegenüber. Gemäss der Erfindung weist die Rauchmeldereinheit 210 die Detektoreinheit 203 zur Detektion der zumindest einen Gefahrenkenngrösse auf. Letztere ist typischerweise eine Mindestrauchdichte oder eine Mindestrauchpartikeldichte. Die Detektoreinheit 203 umfasst ihrerseits einen Lichtsender 201 zur Aussendung eines eine Messstrecke durchquerenden Lichtstrahls LS und einen benachbart angeordneten Lichtempfänger 202 zum Empfangen des ausgesendeten Lichtstrahls LS am Ende der Messstrecke. Der Lichtsender 201 sendet vorzugsweise stark gebündeltes infrarotes Licht aus, wie z.B. mittels eines IR-Lasers oder eine IR-Leuchtdiode. Der Lichtempfänger 202 ist sensitiv für das zu empfangende Licht. Er ist z.B. eine IR-Photodiode oder ein IR-Fototransistor. Die Umlenkeinheit 204 ist im vorliegenden Fall ein Umlenkprisma. Es kann alternativ ein Spiegel oder ein sogenannter Retroreflektor im Sinne eines Katzenauges sein. Die Umlenkeinheit 204 ist dabei zur Umlenkung des vom Lichtsender 201 ausgesandten Lichtstrahls LS zurück auf den Lichtempfänger 202 vorgesehen.

Im vorliegenden Beispiel setzt sich der Lichtstrahl LS aus einem Hinstrahl HS und aus einem Rückstrahl RS zusammen, die in etwa antiparallel zueinander verlaufen. Die dabei vom Lichtstrahl LS durchlaufende Messstrecke setzt sich dabei streckenmässig aus der Länge des Hinstrahls HS und der Länge des Rückstrahls RS, also dem doppelten Abstand zwischen der Rauchmeldereinheit 210 und der Umlenkeinheit 204, zusammen. Erfindungsgemäss weist der lineare Rauchmelder elektrische Bauelemente 6 sowie zumindest einen erfindungsgemässen temperaturgeregelten integrierten Schaltkreis 51 zumindest zur Weiterverarbeitung der jeweiligen detektierten Gefahrenkenngrösse, zur Ausgabe eines Meldersignals SIG und zur Ausgabe einer Schädigungsinformation DEG für den zumindest einen integrierten Schaltkreis 51 durch die einwirkende ionisierende Strahlung auf.

Dadurch ist im Vergleich zum Stand der Technik ein längerer Einsatz des linearen Rauchmelders 200 im Bereich mit erhöhter radioaktiver Strahlendisposition möglich, wie z.B. im sogenannten Sperrbereich NUC eines Kernreaktors in einem Kernkraftwerk.

Alternativ - figürlich nicht dargestellt - können der Lichtsender und der Lichtempfänger auch räumlich getrennt voneinander angeordnet sein. In diesem Fall ist auch keine Umlenkeinheit erforderlich. An der Stelle der gezeigten Umlenkeinheit ist dann der Lichtsender angeordnet und auf den gegenüberliegenden Lichtempfänger ausgerichtet. In diesem Fall entspricht der Abstand zwischen dem Lichtsender und dem Lichtempfänger zugleich der Messstrecke.

### Bezugszeichenliste

- 1: Gefahrenmelder, Brandmelder, Linearer Rauchmelder
- 2: Meldezentrale, Gefahrenmeldezentrale, Panel
- 3: Detektoreinheit, Branddetektoreinheit, optische Messkammer
- 4: Schaltungsträger, Leiterplatte
- 5: Halbleiterbauelement
- 6: weiteres elektrisches Bauelement
- 7: Wärmeisolierung, thermische Isoliereinheit
- 9: Gassensor, Gas-FET
- 11: Meldersockel, Anschlussplatte
- 12: Gehäusegrundkörper
- 13: Gehäuseabdeckung, Gehäusekappe
- 14: sockelseitiger Anschluss
- 15: melderseitiger Anschluss
- 21: Temperatursensor, pn-Diode
- 22: Vergleicher, Differenzbildner, Subtrahierer
- 23: Regler
- 24: Stellglied
- 25: erster Berechnungsblock
- 26: zweiter Berechnungsblock
- 27: Analog-/Digital-Umsetzer
- 28: Umgebungstemperatursensor

- 31: Gassensor-Detektoreinheit
- 32: Hitze-Detektoreinheit, NTC
- 51: Mikrocontroller
- 71: Wärmeisolierhalbschale
- 72: Wärmeisolierplatte
- 100: Gefahrenmeldeanlage, Brandmeldeanlage
- 200: Linearer Rauchmelder (LRM)
- 201: Lichtsender, Laser, Laserdiode
- 202: Lichtempfänger, Photodiode
- 203: Detektoreinheit
- 204: Umlenkeinheit, Reflektor, Retroreflektor
- 210: Rauchmeldereinheit
- ADR: Melderadresse
- ADR1-ADR3: Auswahladresse
- DEG: Schädigungsinformation, Schädigungsgrad
- HS: Hinstrahl
- IN: Eingänge
- LS: Lichtstrahl
- M-PRG: Hauptprogramm
- NUC: Bereich mit erhöhter Radioaktivität, Nuklearbereich
- OF: Gehäuseöffnung
- OUT: Ausgänge
- P₀: Zusatzleistungswert im Startzeitpunkt
- P_{E}: Zusatzleistungswert im Endzeitpunkt
- P_{H}: regelbare elektrische Zusatzleistung
- P_{L}: Leckstromverlustleistung
- P_{MIN}: Mindestleistungswert
- PV-PRG: Verlustleistungssteuerprogramm
- P_{V}: elektrische Leistungsaufnahme, elektrische Verlustleistung
- RS: Rückstrahl
- S: Halbleiterchip, Die
- SIG: Meldersignal, Alarmmeldung, Detektorstatus
- T: Betriebstemperatur
- TI, TI': Temperaturistwert
- TS: Temperatursollwert
- TU: Umgebungstemperatur
- t₀: Startzeitpunkt der Strahlendisposition
- t_{E}: Endzeitpunkt der Strahlendisposition
- t_{W}: Mindestleistungswert
- TC-PRG: Temperaturregelungsprogramm

## Patentansprüche

1. Integrierter Schaltkreis zum Betrieb in einem Bereich (NUC) mit ionisierender Strahlung, mit zumindest einem Teil einer Temperaturregelungsschaltung zur geregelten Erhöhung der Schaltkreistemperatur (T) auf einen vorgegebenen, im Wesentlichen konstanten Betriebstemperaturwert (TS), indem die elektrische Leistungsaufnahme (P_{V}) des Schaltkreises um eine regelbare elektrische Zusatzleistung (P_{H}) erhöht wird, und mit einer Ausgabemöglichkeit für eine Schädigungsinformation (DEG) des integrierten Schaltkreises durch die auf ihn einwirkende ionisierende Strahlung, wobei die Schädigungsinformation (DEG) aus einer strahlendosisabhängigen Abnahme der regelbaren elektrischen Zusatzleistung (P_{H}) ermittelbar ist.

2. Integrierter Schaltkreis nach Anspruch 1, wobei der vorgegebene, im Wesentlichen konstante Betriebstemperaturwert (TS) in einem Bereich von 70°C bis zu einem maximalen, von einem Hersteller des integrierten Schaltkreises spezifizierten Betriebstemperaturwert liegt, wobei der integrierte Schaltkreis insbesondere für einen erweiterten Temperaturbereich oder für einen Hochtemperaturbereich ausgelegt ist.

3. Integrierter Schaltkreis nach Anspruch 1 oder 2, wobei der Schaltkreis einen Halbleiterchip (S) und ein Chipgehäuse aufweist und wobei auf dem Halbleiterchip (S) und/oder im Chipgehäuse zumindest ein elektrisches Heizelement zum Beheizen des integrierten Schaltkreises appliziert ist.

4. Integrierter Schaltkreis nach einem der vorherigen Ansprüche, wobei der integrierte Schaltkreis einen Halbleiterchip (S) aufweist, wobei auf dem Halbleiterchip (S) ein Temperatursensor (21), insbesondere eine pn-Diode, zur Erfassung der Schaltkreistemperatur (T) integriert ist und wobei der Temperatursensor (21) Teil der Temperaturregelungsschaltung ist.

5. Integrierter Schaltkreis nach einem der vorherigen Ansprüche, wobei der integrierte Schaltkreis ein insbesondere in CMOS-Technologie gefertigter Mikrocontroller, Mikroprozessor, FPGA oder ASIC ist.

6. Integrierter Schaltkreis nach Anspruch 5, wobei der Schaltkreis ein prozessorgestützter Schaltkreis ist und wobei zumindest ein Teil der Temperaturregelungsschaltung als Computerprogramm (TC-PRG) realisiert ist, welches auf dem integrierten prozessorgestützten Schaltkreis ausgeführt wird.

7. Integrierter Schaltkreis nach Anspruch 6, wobei der prozessorgestützte Schaltkreis einen Analog-/Digital-Umsetzer (27) zur Erfassung einer vom Temperatursensor (21) ausgegebenen, mit der Schaltkreistemperatur (T) korrelierenden elektrischen Messgrösse aufweist und wobei ein entsprechender Digitalwert durch den prozessorgestützten Schaltkreis zur Temperaturregelung weiterverarbeitet wird.

8. Integrierter Schaltkreis nach Anspruch 6 oder 7, wobei der integrierte prozessorgestützte Schaltkreis ein Mikrocontroller ist, wobei das zur Temperaturregelung auf dem Mikrocontroller ausgeführte Computerprogramm (TC-PRG) geeignete Programmschritte aufweist und/oder ein geeignetes Verlustleistungssteuerungsprogramm (PV-PRG) ansteuert, um interne Funktionsgruppen des Mikrocontrollers wie Timer, Speicher, Takterzeugung, Hardwaremultiplizierer, DMA, Watchdog, serielle Schnittstellen, Komparatoren, DACs sowie analoge oder digitale Ausgänge derart anzusteuern oder derart zeitweise zuzuschalten, sodass die erforderliche elektrische Leistungsaufnahme (P_{V}) zur Regelung der Temperatur des Mikrocontrollers auf den Betriebstemperaturwert (TS) eingestellt werden kann.

9. Integrierter Schaltkreis nach Anspruch 8, wobei die Ansteuerung und/oder das Zuschalten der internen Funktionsbaugruppen durch das Temperaturregelungsprogramms (TC-PRG) derart erfolgt, dass die auf dem Halbleiterchip (S) entstehende Verlustwärme flächenmässig möglichst gleichmässig erfolgt.

10. Integrierter Schaltkreis nach einem der vorherigen Ansprüche 6 bis 9, wobei das Temperaturregelungsprogramms (TC-PRG) geeignete Programmschritte aufweist,
- um die zur Regelung der Temperatur des integrierten Schaltkreises auf den Betriebstemperaturwert (TS) erforderliche elektrische Zusatzleistung (P_{H}) zu ermitteln, und
- um die Schädigungsinformation (DEG) des integrierten Schaltkreises aus einer Abnahme der elektrischen Zusatzleistung (P_{H}) zu ermitteln und auszugeben, und/oder
- um eine Warnmeldung (WARN) auszugeben, falls die erforderliche Zusatzleistung (P_{H}) einen vorgegebenen Minimalwert (P_{MIN}) unterschreitet.

11. Integrierter Schaltkreis nach einem der vorherigen Ansprüche, welcher zusätzlich wärmeisolierend gekapselt ist.

12. Gefahrenmelder, insbesondere Brandmelder, zum Betrieb in einem Bereich (NUC) mit ionisierender Strahlung, wobei der Gefahrenmelder aufweist:
- zumindest eine Detektoreinheit (3, 203) zur Detektion zumindest einer Gefahrenkenngrösse und
- elektrische Bauelemente (6) sowie zumindest einen temperaturgeregelten integrierten Schaltkreis (51) nach einem der vorigen Ansprüche zumindest zur Weiterverarbeitung der jeweiligen detektierten Gefahrenkenngrösse, zur Ausgabe eines Meldersignals (SIG) und zur Ausgabe einer Schädigungsinformation (DEG) für den zumindest einen integrierten Schaltkreis (51) durch die einwirkende ionisierende Strahlung.

13. Als linearer Rauchmelder (200) ausgebildeter Gefahrenmelder (1) nach Anspruch 12, mit einer Rauchmeldereinheit (210) und gegebenenfalls mit zumindest einer Lichtumlenkeinheit (204), wobei die Rauchmeldereinheit (210) die Detektoreinheit (203) mit einem Lichtsender (201) zur Aussendung eines eine Messstrecke durchquerenden Lichtstrahls (LS) und mit einem Lichtempfänger (202) zum Empfangen des ausgesendeten Lichtstrahls (LS) am Ende der Messstrecke aufweist, um die zumindest eine Gefahrenkenngrösse zu detektieren, wobei die zumindest eine Umlenkeinheit (204) zur Umlenkung des vom Lichtsender (201) ausgesandten Lichtstrahls (LS) zurück auf den Lichtempfänger (202) vorgesehen ist, und wobei der lineare Rauchmelder (200) elektrische Bauelemente (6) sowie zumindest einen temperaturgeregelten integrierten Schaltkreis (51) nach einem der vorherigen Ansprüche 1 bis 12 zumindest zur Weiterverarbeitung der jeweiligen detektierten Gefahrenkenngrösse, zur Ausgabe eines Meldersignals (SIG) und zur Ausgabe einer Schädigungsinformation (DEG) für den zumindest einen integrierten Schaltkreis (51) durch die einwirkende ionisierende Strahlung aufweist.

14. Gefahrenmelder nach Anspruch 12 oder 13, wobei die Warnmeldung (WARN) über den zumindest einen integrierten Schaltkreis (51) an eine signal- oder datentechnisch mit dem Gefahrenmelder verbundene Gefahrenmeldezentrale ausgebbar ist, falls die jeweilige elektrische Zusatzleistung (P_{H}) einen vorgegebenen Minimalwert (P_{MIN}) unterschreitet.

15. Verfahren zur Ermittlung einer Schädigungsinformation (DEG) eines integrierten Schaltkreises (51) durch eine auf diesen einwirkende ionisierende Strahlung,
- wobei die Schaltkreistemperatur (T) auf einen vorgegebenen, im Wesentlichen konstanten Betriebstemperaturwert (TS) geregelt erhöht wird, um eine in einem Halbleiterchip (S) des integrierten Schaltkreises (51) durch die ionisierende Strahlung induzierte erhöhte elektrische Löcher-Leitfähigkeit durch eine mit zunehmender Schaltkreistemperatur (T) zunehmende Löcher-Rekombinationsrate zumindest teilweise zu kompensieren,
- wobei zur Erhöhung der Schaltkreistemperatur (T) die elektrische Leistungsaufnahme (P_{V}) des integrierten Schaltkreises um eine regelbare elektrische Zusatzleistung (P_{H}) erhöht wird, und
- wobei die Schädigungsinformation (DEG) des integrierten Schaltkreises (51) aus einer Abnahme der erforderlichen elektrischen Zusatzleistung (P_{H}) ermittelt und dann ausgegeben wird.

## Claims

1. Integrated circuit for operation in an area (NUC) with ionising radiation, with at least one part of a temperature control circuit for the regulated increase of the circuit temperature (T) to a predefined, essentially constant operating temperature (TS), by increasing the electrical power consumption (P_{V}) of the circuit by an adjustable additional electrical power (P_{H}), and with an output facility for information about damage (DEG) to the integrated circuit caused by the ionising radiation impacting thereon, whereas the information about damage (DEG) being determined from a radiation-dose-dependent decrease in the adjustable additional electrical power (P_{H}).

2. Integrated circuit according to claim 1, the predefined, essentially constant operating temperature (TS) lying in a range between 70°C up to a maximum operating temperature specified by a manufacturer of the integrated circuit, the integrated circuit being designed in particular for an extended temperature range or for a high temperature range.

3. Integrated circuit according to claim 1 or 2, the circuit having a semiconductor chip (S) and a chip housing, and at least one electrical heating element for heating up the integrated circuit being applied on the semiconductor chip (S) and/or in the chip housing.

4. Integrated circuit according to one of the preceding claims, the integrated circuit having a semiconductor chip (S), a temperature sensor (21), in particular a pn diode, for detecting the circuit temperature (T) being integrated on the semiconductor chip (S) and the temperature sensor (21) being part of the temperature control circuit.

5. Integrated circuit according to one of the preceding claims, the integrated circuit being a microcontroller, microprocessor, FPGA or ASIC manufactured in particular using CMOS technology.

6. Integrated circuit according to claim 5, the circuit being a processor-aided circuit and at least one part of the temperature control circuit being implemented as a computer program (TC-PRG) which is executed on the integrated processor-aided circuit.

7. Integrated circuit according to claim 6, the processor-aided circuit having an analogue/digital converter (27) for detecting an electrical measured variable output by the temperature sensor (21) and correlating with the circuit temperature (T), and a corresponding digital value being further processed by the processor-aided circuit for temperature control.

8. Integrated circuit according to claim 6 or 7, the integrated processor-aided circuit being a microcontroller, the computer program (TC-PRG) executed on the microcontroller for temperature control having suitable program steps and/or actuating a suitable power loss control program (PV-PRG), in order to actuate or temporarily switch on internal function groups of the microcontroller such as timers, memories, clock generation, hardware multipliers, DMA, watchdog, serial interfaces, comparators, DACs as well as analogue or digital outputs, such that the requisite electrical power consumption (P_{V}) for controlling the temperature of the microcontroller can be set to the operating temperature (TS).

9. Integrated circuit according to claim 8, the actuating and/or switching on of the internal functional modules by the temperature control program (TC-PRG) being effected such that the heat losses arising on the semiconductor chip (S) are effected as evenly as possible across the surface.

10. Integrated circuit according to one of the preceding claims 6 to 9, the temperature control program (TC-PRG) having suitable program steps:
- to determine the additional electrical power (P_{H}) required for regulating the temperature of the integrated circuit to the operating temperature (TS), and
- to determine the information about damage (DEG) to the integrated circuit from a decrease in the additional electrical power (P_{H}) and to output it, and/or
- to output a warning message (WARN) if the requisite additional power (P_{H}) exceeds a predefined minimum value (P_{MIN}).

11. Integrated circuit according to one of the preceding claims, which is additionally encapsulated in heat-insulating fashion.

12. Hazard alarm, in particular fire alarm, for operation in an area (NUC) with ionising radiation, the hazard alarm having:
- at least one detector unit (3, 203) for detecting at least one hazard parameter and
- electrical components (6) as well as at least one temperature-controlled integrated circuit (51) according to one of the preceding claims at least for further processing of the respective detected hazard parameter, for outputting an alarm signal (SIG) and for outputting information about damage (DEG) to the at least one integrated circuit (51) caused by the ionising radiation impacting thereon.

13. Hazard alarm (1) according to claim 12, designed as a linear smoke detector (200), with a smoke detector unit (210) and if appropriate with at least one light deflection unit (204), the smoke detector unit (210) comprising the detector unit (203) with a light emitter (201) for emitting a light beam (LS) traversing a measured distance and with a light receiver (202) for receiving the emitted light beam (LS) at the end of the measured distance, in order to detect the at least one hazard parameter, the at least one deflection unit (204) being provided for deflecting the light beam (LS) emitted by the light emitter (201) back to the light receiver (202), and the linear smoke detector (200) having electrical components (6) as well as at least one temperature-controlled integrated circuit (51) according to one of the preceding claims 1 to 12 at least for further processing of the respective detected hazard parameter, for outputting an alarm signal (SIG) and for outputting information about damage (DEG) to the at least one integrated circuit (51) caused by the ionising radiation impacting thereon.

14. Hazard alarm according to claim 12 or 13, it being possible to output the warning message (WARN) via the at least one integrated circuit (51) to a hazard alarm panel connected to the hazard alarm using signal or data processing technology, if the respective additional electrical power (P_{H}) falls below a predefined minimum value (P_{MIN}).

15. Method for determining information about damage (DEG) to an integrated circuit (51) caused by ionising radiation impacting thereon,
- the circuit temperature (T) being increased in regulated fashion to a predefined, essentially constant operating temperature (TS), in order to at least partially offset an increased electrical hole-type conductivity induced in a semiconductor chip (S) of the integrated circuit (51) by the ionising radiation by a hole recombination rate which increases as the circuit temperature (T) increases,
- the electrical power consumption (P_{V}) of the integrated circuit being increased by an adjustable additional electrical power (P_{H}) to increase the circuit temperature (T), and
- the information about damage (DEG) to the integrated circuit (51) being determined from a decrease in the requisite additional electrical power (P_{H}), and then output.

## Revendications

1. Circuit intégré destiné à fonctionner dans une zone (NUC) exposée aux rayonnements ionisants, avec au moins une partie d'un circuit de régulation de la température pour l'augmentation régulée de la température (T) du circuit à une valeur de température de fonctionnement essentiellement constante prédéterminée (TS), par le fait que l'on augmente la consommation de puissance électrique (P_{V}) du circuit d'une puissance électrique additionnelle réglable (P_{H}), et avec une possibilité de délivrance d'informations sur des détériorations (DEG) du circuit intégré par le rayonnement ionisant agissant sur lui, dans lequel les informations sur des détériorations (DEG) peuvent être déterminées à partir d'une diminution de la puissance électrique additionnelle réglable (P_{H}) en fonction de la dose de rayonnement.

2. Circuit intégré selon la revendication 1, dans lequel la valeur de température de fonctionnement essentiellement constante prédéterminée (TS) se situe dans une plage de 70°C à une valeur de température de fonctionnement maximale spécifiée par un fabricant du circuit intégré, dans lequel le circuit intégré est conçu en particulier pour une plage de température élargie ou pour une plage de haute température.

3. Circuit intégré selon la revendication 1 ou 2, dans lequel le circuit présente une puce à semi-conducteur (S) et un boîtier de puce et dans lequel au moins un élément chauffant électrique destiné au chauffage du circuit intégré est appliqué sur la puce à semi-conducteur (S) et/ou dans le boîtier de puce.

4. Circuit intégré selon l'une quelconque des revendications précédentes, dans lequel le circuit intégré présente une puce à semi-conducteur (S), dans lequel un capteur de température (21), en particulier une diode pn, est intégré sur la puce à semi-conducteur (S) pour la détection de la température (T) du circuit, et dans lequel le capteur de température (21) fait partie du circuit de régulation de la température.

5. Circuit intégré selon l'une quelconque des revendications précédentes, dans lequel le circuit intégré est en particulier un microcontrôleur, un microprocesseur, FPGA ou ASIC fabriqué par la technologie CMOS.

6. Circuit intégré selon la revendication 5, dans lequel le circuit intégré est un circuit intégré assisté par processeur, et dans lequel au moins une partie du circuit de régulation de la température est réalisée sous forme de programme informatique (TC-PRG), qui est exécuté sur le circuit intégré assisté par processeur.

7. Circuit intégré selon la revendication 6, dans lequel le circuit assisté par processeur présente un convertisseur analogique-numérique (27) pour la détection d'une grandeur de mesure électrique en corrélation avec la température (T) du circuit et émise par le capteur de température (21) et dans lequel une valeur numérique correspondante est traitée par le circuit assisté par processeur pour la régulation de la température.

8. Circuit intégré selon la revendication 6 ou 7, dans lequel le circuit intégré assisté par processeur est un microcontrôleur, dans lequel le programme informatique (TC-PRG) exécuté sur le microcontrôleur pour la régulation de la température présente des étapes de programme appropriées et/ou commande un programme approprié de commande de puissance perdue (PV-PRG) destiné à commander des groupes de fonctions internes du microcontrôleur, comme minuteries, mémoires, générateurs d'impulsions, multiplicateurs matériels, DMA, chien de garde, interfaces série, comparateurs, DAC ainsi que des sorties analogiques ou numériques ou de les connecter temporairement, de telle manière que la consommation de puissance électrique nécessaire (P_{V}) pour la régulation de la température du microcontrôleur puisse être réglée à la valeur de température de fonctionnement (TS).

9. Circuit intégré selon la revendication 8, dans lequel la commande et/ou la connexion des groupes de fonctions internes par le programme de régulation de la température (TC-PRG) est effectuée de telle manière que la chaleur perdue dégagée sur la puce à semi-conducteur (S) soit répartie de façon aussi uniforme que possible sur la surface.

10. Circuit intégré selon l'une quelconque des revendications précédentes 6 à 9, dans lequel le programme de régulation de la température (TC-PRG) présente des étapes de programme appropriées,
- pour déterminer la puissance électrique additionnelle (P_{H}) nécessaire pour la régulation de la température du circuit intégré à la valeur de température de fonctionnement (TS), et
- pour déterminer et émettre les informations sur les détériorations (DEG) du circuit intégré à partir d'une diminution de la puissance électrique additionnelle (P_{H}), et/ou
- pour émettre un message d'avertissement (WARN), dans le cas où la puissance additionnelle nécessaire (P_{H}) descend en dessous d'une valeur minimale prédéterminée (P_{MIN}).

11. Circuit intégré selon l'une quelconque des revendications précédentes, qui est en outre encapsulé de façon thermiquement isolante.

12. Avertisseur de danger, en particulier détecteur d'incendie, destiné à fonctionner dans une zone (NUC) exposée aux rayonnements ionisants, dans lequel l'avertisseur de danger présente:
- au moins une unité de détecteur (3, 203) pour la détection d'au moins une grandeur caractéristique d'un danger, et
- des composants électriques (6) ainsi qu'au moins un circuit intégré à régulation de température (51) selon l'une quelconque des revendications précédentes destiné au moins au traitement ultérieur de la grandeur caractéristique d'un danger respective détectée, en vue de l'émission d'un signal d'avertissement (SIG) et en vue de l'émission d'une information sur les détériorations (DEG) pour ledit au moins un circuit intégré (51) causées par le rayonnement ionisant agissant sur lui.

13. Avertisseur de danger (1) selon la revendication 12 réalisé sous forme de détecteur de fumée linéaire (200), avec une unité de détecteur de fumée (210) et éventuellement avec au moins une unité de déviation de la lumière (204), dans lequel l'unité de détecteur de fumée (210) présente l'unité de détecteur (203) avec un émetteur de lumière (201) destiné à émettre un rayon lumineux (LS) traversant une zone de mesure et avec un récepteur de lumière (202) destiné à recevoir le rayon lumineux émis (LS) à l'extrémité de la zone de mesure, afin de détecter ladite au moins une grandeur caractéristique d'un danger, dans lequel ladite au moins une unité de déviation (204) est prévue pour la déviation du rayon lumineux (LS) émis par l'émetteur de lumière (201) en retour vers le récepteur de lumière (202), et dans lequel le détecteur de fumée linéaire (200) présente des composants électriques (6) ainsi qu'au moins un circuit intégré à régulation de température (51) selon l'une quelconque des revendications 1 à 12, destiné au moins au traitement ultérieur de la grandeur caractéristique d'un danger respective détectée, en vue de l'émission d'un signal d'avertissement (SIG) et en vue de l'émission d'une information sur les détériorations (DEG) pour ledit au moins un circuit intégré (51) causées par le rayonnement ionisant agissant sur lui.

14. Avertisseur de danger selon la revendication 12 ou 13, dans lequel le message d'avertissement (WARN) peut être émis par l'intermédiaire dudit au moins un circuit intégré (51) vers une centrale d'avertissement de danger reliée pour la transmission de signaux ou de données à l'avertisseur de danger, dans le cas où la puissance électrique additionnelle respective (P_{H}) descend en dessous d'une valeur minimale prédéterminée (P_{MIN}).

15. Procédé pour la détermination d'une information sur les détériorations (DEG) d'un circuit intégré (51) par un rayonnement ionisant agissant sur celui-ci,
- dans lequel on augmente de façon régulée la température (T) du circuit à une valeur de température de fonctionnement (TS) essentiellement constante prédéterminée, afin de compenser au moins partiellement une conductibilité électrique de trous accrue induite par le rayonnement ionisant dans une puce à semi-conducteur (S) du circuit intégré (51) par une vitesse de recombinaison des trous croissante avec la croissance de la température (T) du circuit,
- dans lequel on augmente la consommation de puissance électrique (P_{V}) du circuit intégré d'une puissance électrique additionnelle réglable (P_{H}) pour augmenter la température (T) du circuit, et
- dans lequel on détermine et ensuite on émet l'information sur les détériorations (DEG) du circuit intégré (51) à partir d'une diminution de la puissance électrique additionnelle nécessaire (P_{H}).
